# EUROPEAN PATENT SPECIFICATION

(11) **EP 3 806 601 B1**
(45) Date of publication and mention of the grant of the patent: **02.08.2023**
(21) Application number: 18920673.3
(22) Date of filing: 01.06.2018
(51) Int. Cl.: H05K 13/04

(54) **TAPE FEEDER**
BANDZUFÜHRER
DISPOSITIF D'ALIMENTATION DE BANDE

(43) Date of publication of application: 14.04.2021
(73) Proprietor: Fuji Corporation, Chiryu-shi, Aichi 472-8686 (JP)
(72) Inventor: TANAKA Keita, Chiryu-shi, Aichi 472-8686 (JP); HOSOI Norio, Chiryu-shi, Aichi 472-8686 (JP); NARITA, Haruna, Chiryu, Aichi 472-8686 (JP)
(74) Representative: Grünecker Patent- und Rechtsanwälte PartG mbB
(86) International application number: PCT/JP2018/021264
(87) International publication number: WO 2019/229993

(56) References cited:
- JP-A- H0 466 461
- JP-A- 2007 073 791
- JP-A- 2007 510 296
- JP-A- 2010 050 380
- JP-A- 2010 212 681
- JP-A- 2013 206 963
- JP-A- 2014 120 622
- JP-A- 2017 117 922
- JP-A- 2018 082 200
- US-A1- 2016 185 093

## Description

### Technical Field

The present invention relates to a tape feeder.

### Background Art

A carrier tape having a base tape in which an electronic component is accommodated and a cover tape for preventing the electronic component from falling off by being bonded to the base tape is known. When conveying the electronic component accommodated in the carrier tape to a component supply position by the tape feeder, the tape feeder is required to peel off the cover tape from the base tape. Therefore, the tape feeder is provided with a peeling blade that peels off the cover tape from the base tape on an upstream side in a conveyance direction of the carrier tape from the component supply position.

Here, a driving sprocket for pitch feeding the carrier tape is provided in the tape feeder. An operator, when newly setting a reel around which the carrier tape is wound, is required to pull out the carrier tape from the reel and convey the carrier tape to an engaging position of the carrier tape and the driving sprocket. In addition, when the peeling blade is provided on the upstream side in the conveyance direction of the carrier tape from the engaging position of the carrier tape and the driving sprocket, the operator needs to convey the carrier tape to the engaging position with the driving sprocket in a state where the cover tape is peeled off from the base tape. On the other hand, the carrier tape is flexible. When the operator directly applies a propulsion force to the carrier tape, it is difficult to peel off the carrier tape due to a load of the peeling blade. Therefore, in order to peel off the cover tape from the base tape by the peeling blade, the operator needs to use a sprocket to convey the carrier tape while applying the propulsion force in the conveyance direction through the feeding hole formed in the carrier tape.

Regarding this point, Patent Literature 1 discloses a tape feeder having a first driving sprocket that engages with the carrier tape on the downstream side in the conveyance direction of the carrier tape from a tape peeling unit and a second driving sprocket that engages with the carrier tape at the upstream side in the conveyance direction of the carrier tape from the tape peeling unit. In this case, the propulsion force is applied to the carrier tape by driving the second driving sprocket with which the carrier tape is engaged. As a result, the carrier tape is conveyed to an engaging position with the first driving sprocket in a state where the cover tape is peeled off from the base tape by the peeling blade.

Patent Literature 2 discloses a tape feeder provided with a sprocket that can be manually rotated on the upstream side in the conveyance direction of the carrier tape from the peeling section. In this case, the propulsion force is applied to the carrier tape by manually operating the sprocket with which the carrier tape is engaged.

### Patent Literature

Patent Literature 1: JP-6271563
Patent Literature 2: JP-A-4-66461

### Summary of the Invention

### Technical Problem

The tape feeder described in Patent Literature 1 described above needs to be provided with multiple driving sprockets, and requires a driving mechanism for driving multiple driving sprockets. In addition, since it is necessary to synchronize the first driving sprocket and the second driving sprocket, a structure of the tape feeder becomes complicated. In this case, in order to accurately position the electronic component to be conveyed at the component supply position, since high accuracy is required both the first driving sprocket and the second driving sprocket, a component cost is increased.

On the other hand, in the tape feeder of Patent Literature 2 described above, dust or the like is likely to adhere to the electronic component since a stroke from the cover tape is peeled off by the peeling blade until the electronic component reaches the component supply position is long, and the time for conveying the base tape in a state where the electronic component is exposed is long.

An object of the present specification is to provide a tape feeder which can suppress adhesion of dust or the like to an electronic component while reducing the component cost by simplifying the structure.

### Solution to Problem

The invention is defined by the features of claim 1. Further embodiments are defined in the dependent claims.

### Advantageous Effect of the Invention

According to the tape feeder disclosed in the present specification, since a manual sprocket can be manually operated, the component cost can be reduced as compared with a case of using a sprocket driven by a driving mechanism such as a motor. In this case, the manual sprocket can simplify a structure of the tape feeder since synchronous rotation with the driving sprocket is not necessary.

Furthermore, the manual sprocket is provided at a position where a conveying distance of the carrier tape from the engaging position with the feeding hole to the peeling blade is longer than a conveying distance of the carrier tape from the peeling blade to the component supply position. Accordingly, it is possible to shorten a stroke until the electronic component is conveyed to the component supply position after the cover tape is peeled off, so that the tape feeder can suppress dust or the like from adhering to the electronic component. Furthermore, in this case, the tape feeder can reduce an effect of the accuracy of the manual sprocket on the positioning accuracy of the electronic component to be conveyed to the component supply position. Therefore, the tape feeder can relax the accuracy required for the manual sprocket while improving the positioning accuracy of the electronic component, so that the component cost can be reduced.

### Brief Description of Drawings

Fig. 1 a diagram schematically showing an overall configuration of a component mounter in an embodiment of the present invention.
Fig. 2 is a top view schematically showing a carrier tape.
Fig. 3 is a side view schematically showing a main part of a tape feeder.
Fig. 4 is a partially enlarged side view of the tape feeder showing an enlarged position where a first tape pressing section and a peeling section are provided.
Fig. 5 is a partially enlarged perspective view of the tape feeder and shows an enlarged position where the first tape pressing section and the peeling section are provided.
Fig. 6 is a partially enlarged sectional view of the tape feeder in VI-VI line of Fig. 4.
Fig. 7 is a schematic view showing a state before the peeling blade is inserted between a base tape and a cover tape.
Fig. 8 is a schematic view showing a state after the peeling blade is inserted between the base tape and the cover tape, and shows a state where one side of the cover tape in a width direction is raised.
Fig. 9 is a top view schematically showing the carrier tape, and shows a state where a part of the cover tape is peeled off from the base tape.

### Description of Embodiments

### 1. Schematic configuration of component mounter 1

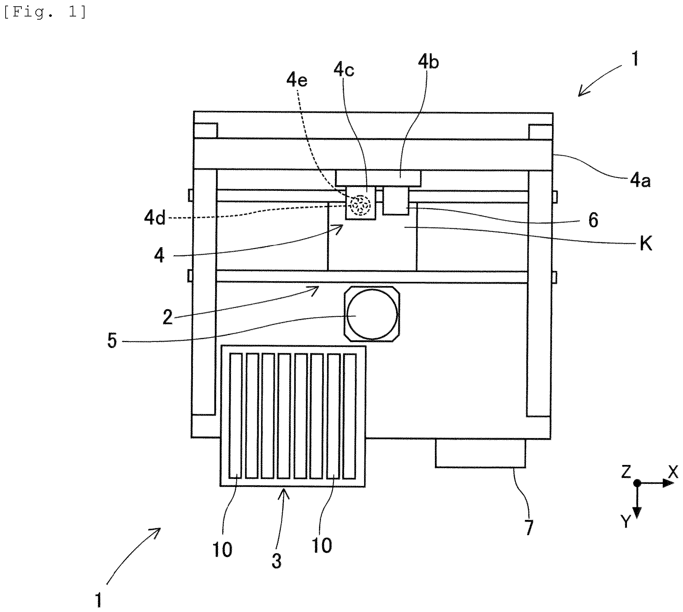

Hereinafter, embodiments to which the tape feeder disclosed in the present description is applied will be described with reference to the drawings. First, a schematic configuration of component mounter 1 using tape feeder 10 will be described with reference to Fig. 1. In Fig. 1, a horizontal width direction of component mounter 1 (right and left direction of Fig. 1) is an X direction, a horizontal longitudinal direction of component mounter 1 (up and down direction of Fig. 1) is Y direction, a vertical direction perpendicular to the X direction and Y direction (direction perpendicular to paper surface of Fig. 1) is a Z direction.

As shown in Fig. 1, component mounter 1 mainly includes board conveyance device 2, component supply device 3, component transfer device 4, part camera 5, board camera 6, and control device 7. Board conveyance device 2 is configured with a belt conveyor or the like, and subsequently conveys circuit board K in the X direction. Board conveyance device 2 positions circuit board K at a predetermined position inside of component mounter 1. When the processing for positioned circuit board K is completed, board conveyance device 2 conveys circuit board K to an outside of component mounter 1.

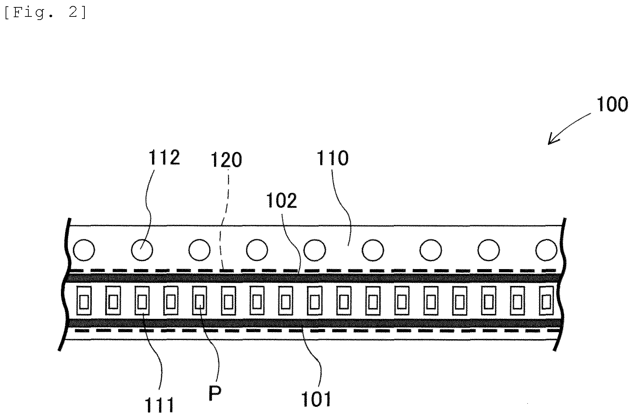

Component supply device 3 supplies an electronic component to be mounted on circuit board K (hereinafter, referred to as "component P"). Component supply device 3 includes multiple slots arranged in the X direction, and tape feeder 10 is detachably set in each of the multiple slots. Component supply device 3 feeds and moves carrier tape 100 (see Fig. 2) by tape feeder 10, and supplies component P to component supply position Ps provided on a tip end side of tape feeder 10 (upper side of Fig 1).

Component transfer device 4 holds component P supplied to component supply position Ps, and mounts held component P to positioned circuit board K. Component transfer device 4 mainly includes head driving device 4a, moving table 4b, and mounting head 4c. Head driving device 4a is configured to move moving table 4b in the X direction and the Y direction by a linear motion mechanism. Mounting head 4c is a holding device for holding component P, and is configured to be detachable from moving table 4b. In nozzle holder 4d provided in mounting head 4c, multiple suction nozzles 4e capable of holding component P is detachably provided.

Suction nozzle 4e is supported about an axis parallel to the Z direction to be rotatable and elevatable, with respect to mounting head 4c. Suction nozzle 4e holds component P supplied to component supply position Ps by suction pickup, and mounts held component P to positioned circuit board K.

Part camera 5 and board camera 6 are digital imaging devices having imaging elements such as a CCD or a CMOS. Part camera 5 is fixed to a base of component mounter 1 in a state of directing an optical axis in the Z direction, and images component P held by suction nozzle 4e from below. Board camera 6 is fixed to moving table 4b in a state of directing the optical axis in a Z-axis direction, and images circuit board K from above. Control device 7 is configured with a computer device having CPU. Control device 7 operates by software, and performs a mounting operation of component P in accordance with a sequence stored in advance.

### 2. Carrier tape 100

Next, carrier tape 100 will be described with reference to Fig. 2. As shown in Fig. 2, carrier tape 100 includes base tape 110 and cover tape 120. Base tape 110 is made of a flexible material such as paper material or resin. On one side of base tape 110 in a width direction (lower side of Fig. 2), multiple cavities 111 capable of accommodating component P are formed at equal intervals along a longitudinal direction of base tape 110 (right and left direction of Fig. 2). On the other side of base tape 110 in the width direction (upper side of Fig. 2), multiple feeding holes 112 are formed at equal intervals along the longitudinal direction of base tape 110. These multiple feeding holes 112 engage with driving sprocket 40 and manual sprocket 70.

Cover tape 120 is formed of a transparent polymer film. In Fig. 2, cover tape 120 is shown by a broken line. Cover tape 120 covers an upper surface of base tape 110 to prevent component P accommodated in cavity 111 from falling off. In addition, base tape 110 and cover tape 120 are bonded to each other at bonding portions 101 and 102 provided on both sides of carrier tape 100 sandwiching cavity 111 in the width direction. These bonding portions 101 and 102 are provided on one side in the width direction of carrier tape 100 from feeding hole 112.

### 3. Schematic configuration of tape feeder 10

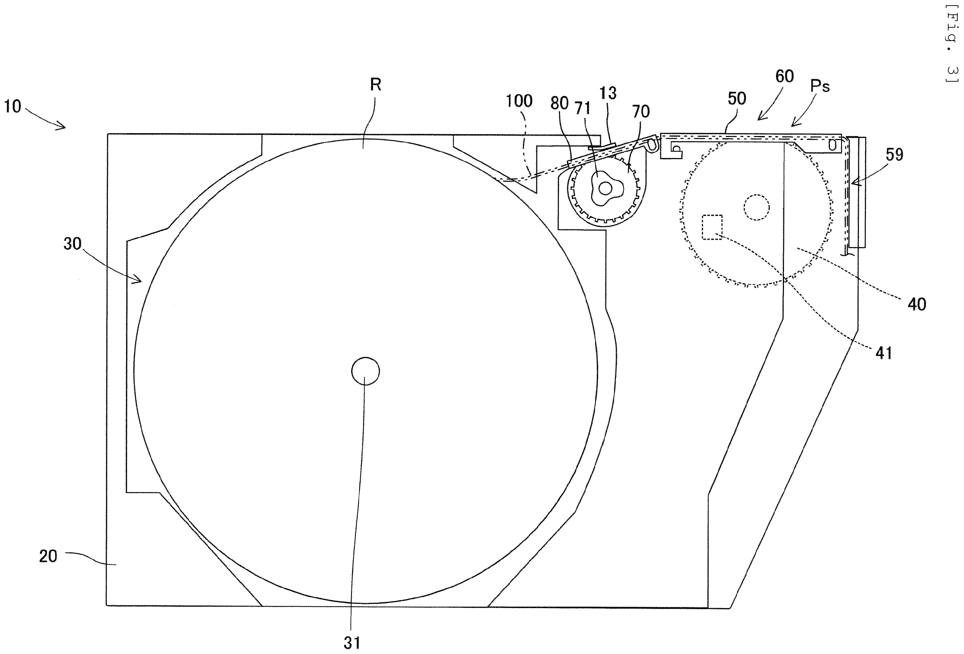

Next, a schematic configuration of tape feeder 10 will be described with reference to Fig. 3. As shown in Fig. 3, tape feeder 10 mainly includes feeder main body 20, reel holding section 30, driving sprocket 40, first tape pressing section 50, and peeling section 60.

Feeder main body 20 is a thin box-like member formed of a transparent or opaque plastic plate, a metal plate, or the like. A side surface of feeder main body 20 is openably/closably provided, and reel holding section 30 exchangeably holds reel R around which carrier tape 100 is wound. Reel holding section 30 may be provided integrally with feeder main body 20, or may be a separate body from feeder main body 20. Reel holding section 30 includes rotatable reel holding shaft 31, and reel R is rotatably held with respect to feeder main body 20 by being mounted on reel holding shaft 31.

Driving sprocket 40 is a sprocket which is capable of engaging with feeding hole 112 provided in base tape 110, and is rotatably provided in feeder main body 20. Tape feeder 10 includes motor 41 and multiple gears (not shown). Motor 41 is a stepping motor, and multiple gears reduces rotation speed of a driving shaft of motor 41 and transmits the rotation to driving sprocket 40. Driving sprocket 40 is driven by motor 41, and motor 41 pitch feeds carrier tape 100 via driving sprocket 40 and conveys component P (see Fig. 2) to component supply position Ps.

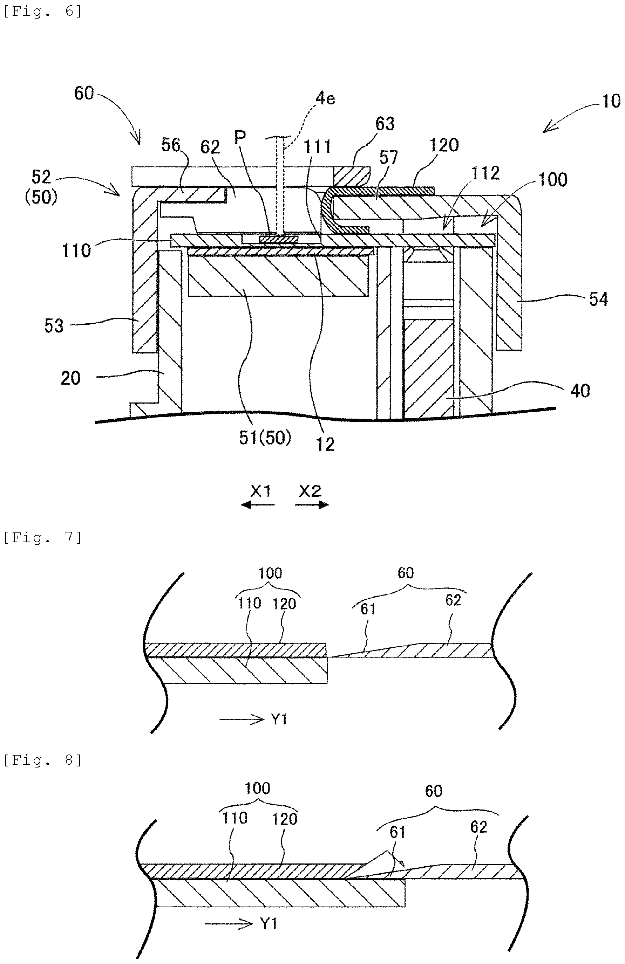

Here, component supply position Ps, when viewed from a rotational axis direction of driving sprocket 40 (X direction), is provided above a position where driving sprocket 40 is disposed. Accordingly, since the engaging position of carrier tape 100 and driving sprocket 40 can be disposed at a position close to component supply position Ps, tape feeder 10 increases positioning accuracy of component P to be conveyed to component supply position Ps. Component supply position Ps is provided at a position shifted in the X direction with respect to the position where driving sprocket 40 is disposed when viewed from the Y direction (see Fig. 6).

First tape pressing section 50 guides carrier tape 100 pulled out from reel R so that component P is conveyed to component supply position Ps. Peeling section 60, during component P reaches component supply position Ps, peels off cover tape 120 from base tape 110, and brings component P accommodated in cavity 111 into a state where component P can be picked up by suction nozzle 4e (see Fig. 1).

### 4. First tape pressing section 50 and peeling section 60

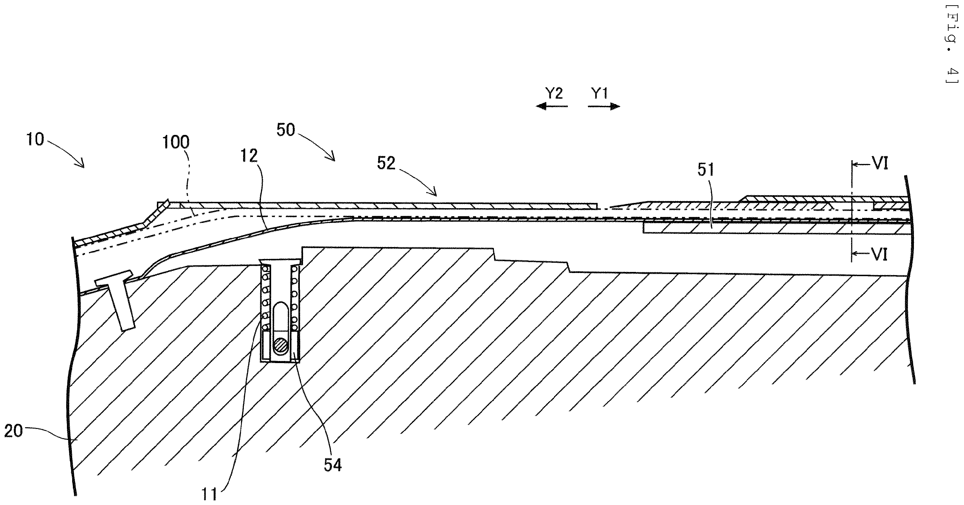

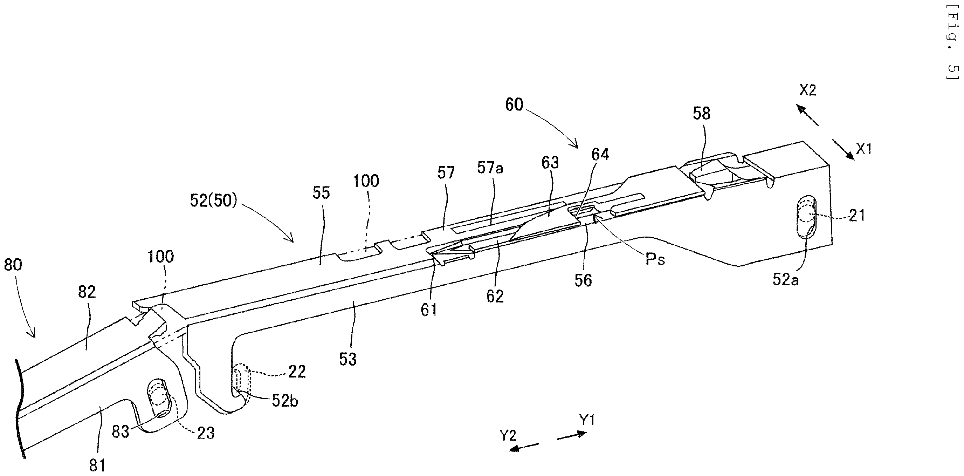

Here, first tape pressing section 50 and peeling section 60 will be described with reference to Figs. 4 to 6. As shown in Figs. 4 to 6, first tape pressing section 50 mainly includes support section 51 for supporting carrier tape 100 from below, and guide section 52 for covering carrier tape 100 from both an upper part and the width direction (X direction). Support section 51 is fixed to feeder main body 20 at a position including component supply position Ps, and the position is one side of driving sprocket 40 in the width direction (hereinafter, referred to as "X1 side").

Guide section 52 is swingably supported with respect to feeder main body 20, and swings up and down depending on a thickness dimension of carrier tape 100 passing between guide section 52 and support section 51. In tape feeder 10, first biasing member 11 for biasing guide section 52 downward with respect to feeder main body 20 is provided, and guide section 52 presses carrier tape 100 from above.

Guide section 52 includes a pair of side wall sections 53 and 54, first guide section 55, second guide section 56, third guide section 57, and fourth guide section 58. The pair of side wall sections 53 and 54 are plate-shaped portions provided on both sides in the X direction with support section 51 interposed therebetween. The pair of side wall sections 53 and 54 regulates carrier tape 100 to be conveyed from deviating in the X direction.

In the pair of side wall sections 53 and 54, long hole 52a into which pin 21 provided in feeder main body 20 is inserted is formed on a downstream side in a conveyance direction of carrier tape 100 (hereinafter, referred to as "Y1 side"). That is, the pair of side wall sections 53 and 54 are swingably supported with respect to feeder main body 20. The pair of side wall sections 53 and 54 is connected by pin 52b on an upstream side in the conveyance direction of carrier tape 100 (hereinafter, referred to as "Y2 side"), and pin 52b is inserted into long hole 22 formed in feeder main body 20. Then, pin 52b is biased downward with respect to feeder main body 20 by first biasing member 11.

First guide section 55 is a portion covering carrier tape 100 on the Y2 side from peeling section 60, and first guide section 55 is connected to upper ends of the pair of side wall sections 53 and 54. Second biasing member 12 for biasing carrier tape 100 upward is provided below first guide section 55. Second biasing member 12 is a plate spring extending in the Y direction and is fixed to feeder main body 20. First guide section 55 extends in the horizontal direction, and carrier tape 100 pressed against first guide section 55 by second biasing member 12 is conveyed in a horizontal state.

Second guide section 56 and third guide section 57 are provided on the Y1 side from first guide section 55. Second guide section 56 is a portion that protrudes from an upper end of one side wall section 53 located on the X1 side of the pair of side wall sections 53 and 54 to the other side in the width direction (hereinafter, referred to as "X2 side"). Peeling section 60 is fixed to second guide section 56.

Third guide section 57 is a portion that protrudes toward the X1 side from the upper end of the other side wall section 54 located on the X2 side of the pair of side wall sections 53 and 54. Third guide section 57 is located above the position where driving sprocket 40 is disposed and does not overlap vertically with cavity 111 provided in carrier tape 100 to be conveyed. An upper surface of third guide section 57 is located lower than an upper surface of second guide section 56. In the engaging position of feeding hole 112 and driving sprocket 40, through hole 57a for avoiding interference with driving sprocket 40 is formed in third guide section 57.

Fourth guide section 58 is provided on the Y1 side from second guide section 56 and third guide section 57. Fourth guide section 58 guides carrier tape 100 passed through component supply position Ps downward. In feeder main body 20, collection section 59 (see Fig. 3) through which carrier tape 100 passes is provided below fourth guide section 58. Carrier tape 100 after component P is picked up is collected in a collecting case (not shown) provided outside tape feeder 10 via collection section 59.

Peeling section 60 mainly includes peeling blade 61, insertion section 62, and folded-back section 63. Peeling blade 61 is provided on the Y2 side from component supply position Ps. Peeling blade 61 is a cutter that peels off cover tape 120 from base tape 110. Peeling blade 61 enters between base tape 110 and cover tape 120 of conveyed carrier tape 100. Specifically, peeling blade 61 enters one bonding portion 101 located at a position (X1 side) away from feeding hole 112 among bonding portions 101 and 102 (see Fig. 2) between cover tape 120 and base tape 110, provided on both sides in the width direction, and peels off cover tape 120 from base tape 110. At this time, peeling blade 61 does not enter the other bonding portion 102, and carrier tape 100 is conveyed in a state where base tape 110 and cover tape 120 are bonded at the other bonding portion 102.

Insertion section 62 is a portion extending from peeling blade 61 to the Y1 side and is bonded to second guide section 56. As shown in Figs. 7 and 8, insertion section 62 enters between base tape 110 and cover tape 120 to be conveyed, and maintains a state where one side of cover tape 120 in the width direction peeled off from base tape 110 is floated from base tape 110. At this time, since the other bonding portion 102 passes the X2 side from insertion section 62, carrier tape 100 maintains the state where base tape 110 and cover tape 120 are bonded to each other in the other bonding portion 102. As a result, carrier tape 100 is conveyed in a state where cover tape 120 is sandwiched between insertion section 62 and third guide section 57.

It is desirable that insertion section 62 is provided so that an end section on the X2 side is at a position equivalent to an end section on the X2 side of cavity 111 of carrier tape 100 to be conveyed, or is located on the X2 side from the end section on the X2 side of cavity 111. As a result, peeling section 60 can float cover tape 120 from base tape 110 at the position where cavity 111 is provided.

Folded-back section 63 is a portion provided on the Y1 side from peeling blade 61 and is bonded to the upper surfaces of second guide section 56 and insertion section 62. In folded-back section 63, cutout section 64 is provided at a position to be component supply position Ps. As a result, since the upper surface of carrier tape 100 is exposed at component supply position Ps, component mounter 1 can pick up component P accommodated in cavity 111 by suction nozzles 4e.

In addition, folded-back section 63 is formed so as to increase a width dimension as it approaches component supply position Ps from the tip end side toward the Y2 side. In the vicinity of component supply position Ps, end section of folded-back section 63 on the X2 side protrudes toward the X2 side from third guide section 57. That is, folded-back section 63 and third guide section 57 overlap each other vertically in the vicinity of component supply position Ps. A lower surface of folded-back section 63 is located above the upper surface of third guide section 57, and a gap is formed between the lower surface of folded-back section 63 and the upper surface of third guide section 57 in a portion where folded-back section 63 and third guide section 57 overlap each other vertically.

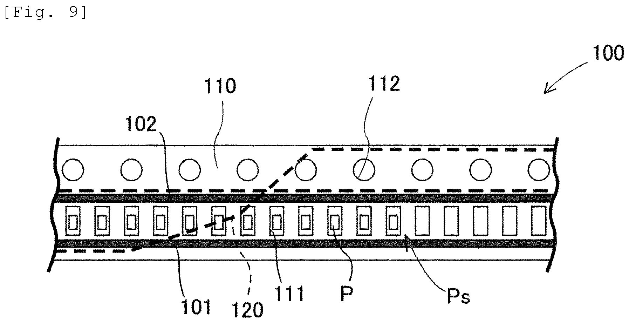

Therefore, as shown in Figs. 6 and 9, when carrier tape 100 is conveyed to a position where folded-back section 63 is provided, cover tape 120 sandwiched between insertion section 62 and third guide section 57 is folded back, and one side of cover tape 120 in the width direction is directed to the X2 side. Thus, cavity 111 which has been covered with cover tape 120 is opened, and carrier tape 100 is conveyed to component supply position Ps in a state where component P accommodated in cavity 111 is exposed.

Here, tape feeder 10 can open entire cavity 111 by providing insertion section 62 so that the end section of insertion section 62 on the X2 side is located at the same position as the end section of cavity 111 on the X2 side, or is located on the X2 side from the end section of cavity 111 on the X2 side. In this case, when raising component P picked up by suction nozzle 4e, component mounter 1 can prevent component P from interfering with cover tape 120.

After component P is picked up by the suction nozzle 4e, base tape 110 is guided to collection section 59 by fourth guide section 58. Since cover tape 120 is bonded to base tape 110 in the other bonding portion 102, it is guided to collection section 59 following base tape 110. In this case, tape feeder 10 does not need to be provided a collection space inside tape feeder 10 for collecting cover tape 120, as a case of peeling off cover tape 120 from base tape 110 at both one bonding portion 101 and the other bonding portion 102. Therefore, tape feeder 10 can hold larger reel R in reel holding section 30 without increasing the size of tape feeder 10.

In addition, when setting new reel R to reel holding section 30, the operator does not need to handle cover tape 120 so that peeled cover tape 120 is collected in the collection space provided inside tape feeder 10. Therefore, tape feeder 10 can reduce the operation performed by the operator when setting new reel R to reel holding section 30. As a result, tape feeder 10 can shorten the time required for the exchange operation of reel R.

### 5. Manual sprocket 70 and second tape pressing section 80

As shown in Fig. 3, tape feeder 10 further includes manual sprocket 70 and second tape pressing section 80. Manual sprocket 70 is a sprocket which can be engaged with feeding hole 112 provided in base tape 110, and manual sprocket 70 is provided between reel holding section 30 and first tape pressing section 50 in the conveyance direction of carrier tape 100. Manual sprocket 70, after mounting new reel R to reel holding section 30, is used when conveying carrier tape 100 pulled out from reel R to the engaging position with driving sprocket 40. Manual sprocket 70 can be manually operated by an operator, and manual sprocket 70 is provided with knob section 71 used for the operation of manual sprocket 70 by the operator.

Here, an operation to be performed when new reel R is mounted on reel holding section 30 will be described. After mounting new reel R to the reel, the operator pulls out carrier tape 100 from reel R, and engages feeding hole 112 with manual sprocket 70. Thereafter, the operator rotates manual sprocket 70 by operating knob section 71. Thus, carrier tape 100 is conveyed toward the engaging position with driving sprocket 40. Then, by engaging conveyed carrier tape 100 with driving sprocket 40, tape feeder 10 is in a state capable of pitch feeding of carrier tape 100 by driving sprocket 40.

Here, tape feeder 10 can apply a propulsion force to carrier tape 100 by conveying carrier tape 100 in a state where carrier tape 100 is engaged with manual sprocket 70. Therefore, tape feeder 10 can smoothly insert peeling blade 61 between base tape 110 and cover tape 120. In addition, carrier tape 100 is conveyed to a position where cover tape 120 is peeled off by peeling blade 61, the engaging position of driving sprocket 40 and carrier tape 100, and component supply position Ps in a state in which the carrier tape becomes horizontal by support section 51 and first guide section 55. Therefore, tape feeder 10 can increase the positioning accuracy of component P to be conveyed to component supply position Ps.

Tape feeder 10 also rotates manual sprocket 70 by manual operation by an operator to convey carrier tape 100 to the engaging position with driving sprocket 40. In this case, as compared with a case of providing a sprocket driven by a motor or the like instead of manual sprocket 70, tape feeder 10 can suppress the component cost as the driving mechanism for driving the sprocket is not required. In this case, since tape feeder 10 does not need to rotate manual sprocket 70 and driving sprocket 40 synchronously, the structure of tape feeder 10 can be simplified.

In component mounter 1, if component P is not supplied appropriately to component supply position Ps, component P cannot be picked up by suction nozzle 4e, and component suction error occurs. In that regard, it is desirable for tape feeder 10 to use high-accuracy driving sprocket 40 to bring the engaging position of driving sprocket 40 and carrier tape 100 close to component supply position Ps in order to suppress component suction error.

On the other hand, manual sprocket 70 is supported by feeder main body 20 in a freely rotatable state. Therefore, when the pitch feeding of carrier tape 100 is performed by driving sprocket 40, manual sprocket 70 rotates, associating with carrier tape 100 conveyed by driving sprocket 40. In this case, in tape feeder 10, the positioning accuracy of component P disposed in component supply position Ps depends on driving sprocket 40.

That is, tape feeder 10 can reduce the effect of the accuracy of manual sprocket 70 on the positioning accuracy of component P. Thus, tape feeder 10 can mitigate the accuracy required for manual sprocket 70 to be lower than the accuracy required for driving sprocket 40. In the present embodiment, driving sprocket 40 is formed of a metal material, whereas manual sprocket 70 is formed of a resin material. In this case, tape feeder 10 can suppress the manufacturing cost of manual sprocket 70 in comparison with driving sprocket 40.

Furthermore, manual sprocket 70 is rotatably provided in feeder main body 20 at a position where a conveying distance of carrier tape 100 from the engaging position of feeding hole 112 and manual sprocket 70 to peeling blade 61 is longer than a conveying distance of carrier tape 100 from peeling blade 61 to component supply position Ps. Therefore, tape feeder 10 can reduce the effect of the accuracy of manual sprocket 70 on the positioning accuracy of component P at component supply position Ps. Thus, tape feeder 10 can mitigate the accuracy required for manual sprocket 70 as compared to driving sprocket 40.

Second tape pressing section 80 is provided above manual sprocket 70. Second tape pressing section 80 includes a pair of side wall sections 81 and upper wall section 82. The pair of side wall sections 81 is located on both sides in the X direction sandwiching manual sprocket 70. Opposing interval of the pair of side wall sections 81 in the X direction is larger than a width dimension of carrier tape 100 and regulates carrier tape 100 pulled out from reel R from deviating in the X direction. In side wall section 81, lone hole 83 into which pin 23 provided in feeder main body 20 is inserted is formed, and the pair of side wall sections 81 is swingably supported with respect to feeder main body 20.

Upper wall section 82 covers carrier tape 100 from above. Upper wall section 82 is connected to an upper end of the pair of side wall sections 81, and swings depending on a thickness of carrier tape 100. In tape feeder 10, third biasing member 13 for biasing second tape pressing section 80 to feeder main body 20 downward is provided. Accordingly, tape feeder 10 can maintain a state where feeding hole 112 is engaged with manual sprocket 70 by pressing carrier tape 100 from above by upper wall section 82. As a result, the operator can simplify the operation of conveying carrier tape 100 by operating manual sprocket 70. In the present embodiment, a plate spring is used for third biasing member 13, but a coil spring or the like may be used instead.

Here, the engaging position of manual sprocket 70 and feeding hole 112 is located lower than the engaging position of driving sprocket 40 and feeding hole 112, and second tape pressing section 80 presses carrier tape 100 in a state in which second tape pressing section 80 is inclined to rise toward the Y1 side. Accordingly, tape feeder 10 can dispose manual sprocket 70 and second tape pressing section 80 in an empty space of feeder main body 20. In this regard, tape feeder 10 does not require a driving mechanism to drive manual sprocket 70, so that the degree of freedom in the disposing position in feeder main body 20 can be increased. On the other hand, since first tape pressing section 50 guides carrier tape 100 to be conveyed horizontally, tape feeder 10 can increase the positioning accuracy of component P to be conveyed to component supply position Ps.

As described above, in tape feeder 10, since manual sprocket 70 can be manually operated, as compared with the case where a sprocket driven by a motor or the like is used instead of manual sprocket 70, the component cost can be reduced as the driving mechanism for driving the sprocket is not required. In this case, manual sprocket 70 does not require synchronous rotation with driving sprocket 40, so that the structure of tape feeder 10 can be simplified.

Furthermore, manual sprocket 70 is provided at a position where the conveying distance of carrier tape 100 from the engaging position with feeding hole 112 to peeling blade 61 is longer than the conveying distance of carrier tape 100 from peeling blade 61 to component supply position Ps. Thus, it is possible to shorten the stroke until component P is conveyed to component supply position Ps after cover tape 120 is peeled off, so that tape feeder 10 can suppress dust or the like from adhering to component P. Furthermore, in this case, tape feeder 10 can reduce the effect of the accuracy of manual sprocket 70 on the positioning accuracy of component P to be conveyed to component supply position Ps. Thus, since tape feeder 10 can relax accuracy required for manual sprocket 70 while improving the positioning accuracy of component P, it is possible to reduce the component cost.

For example, in the present embodiment, a case where peeling section 60 peels off cover tape 120 in one bonding portion 101 from base tape 110 while conveying base tape 110 to component supply position Ps in a state where cover tape 120 in the other bonding portion 102 is bonded to base tape 110 has been described. However, the present invention is not limited thereto, the peeling section may convey base tape 110 to component supply position Ps in a state of peeling cover tape 120 from base tape 110 at both one bonding portion 101 and the other bonding portion 102.

### Reference Signs List

10: tape feeder, 13: third biasing member, 20: feeder main body, 40: driving sprocket, 41: motor, 50: first tape pressing section, 61: peeling blade, 70: manual sprocket, 80: second tape pressing section, 100: carrier tape, 101,102: bonding portion, 110: base tape, P: component (electronic component), Ps: component supply position, R: reel

## Claims

1. A tape feeder (10) comprising:
a feeder main body (20);
a driving sprocket (40) which is a sprocket configured to engage with feeding holes (112) provided in a carrier tape (100) having a base tape (110) accommodating an electronic component (P) and a cover tape (120) bonded to an upper surface of the base tape (110), the driving sprocket (40) being rotatably provided in the feeder main body (20), and configured to be driven by a motor (41) and to convey the electronic component (P) to a predetermined component supply position (Ps) by pitch-feeding the carrier tape (100);
a peeling section (60) comprising a peeling blade (61), being provided on an upstream side in a conveyance direction of the carrier tape (100) from an engaging position of the driving sprocket (40) and the feeding holes (112), which is configured to peel off at least a part of a bonding portion (101) between the cover tape (120) and the base tape (110);
a first tape pressing section (50) configured to press the carrier tape (100) at a position where the cover tape (120) is peeled off by the peeling blade (61), at the component supply position (Ps), and at the engaging position of the driving sprocket (40) and the feeding holes (112);
a manual sprocket (70), being a sprocket engageable with the feeding holes (112) and provided on an upstream side of the first tape pressing section (50); and
a second tape pressing section (80) configured to press the carrier tape (100) above the manual sprocket (70) so as to maintain a state of the feeding holes (112) engaged with the manual sprocket (70),
**characterized in that**
the manual sprocket (70) is provided in the feeder main body (20) to be rotatable at a position where a conveying distance of the carrier tape (100) from the engaging position of the manual sprocket (70) with the feeding holes (112) to the peeling blade (61) is longer than a conveying distance of the carrier tape (100) from the peeling blade (61) to the component supply position (Ps), which is configured to be manually operated to convey the carrier tape (100) pulled out from a reel (R), around which the carrier tape (100) is wound, to the first tape pressing section (50).

2. The tape feeder (10) according to claim 1, wherein the engaging position of the driving sprocket (40) and the feeding holes (112) are provided at a position closer to the component supply position (Ps) than the peeling blade (61).

3. The tape feeder (10) according to claim 1 or 2, further comprising: a collection section (59) configured to collect the carrier tape (100) after the electronic component (P) is picked up and the cover tape (120) bonded to the carrier tape (100) on a downstream side in the conveyance direction of the carrier tape (100) from the component supply position (Ps).

4. The tape feeder (10) according to any one of claims 1 to 3,
wherein the first tape pressing section (50) is configured to press the carrier tape (100) in a state in which the carrier tape (100) is horizontal, and
the second tape pressing section (80) is configured to press the carrier tape (100) in a state in which the second tape pressing section (80) is inclined to rise toward the downstream side from the upstream side in the conveyance direction of the carrier tape (100).

5. The tape feeder (10) according to claim 4, further comprising:
a biasing member (13) configured to bias the second tape pressing section (80) downward with respect to the feeder main body (20).

6. The tape feeder (10) according to any one of claims 1 to 5,
wherein the component supply position (Ps) is provided above a position where the driving sprocket (40) is disposed when viewed in a rotational axis direction of the driving sprocket (40).

## Patentansprüche

1. Bandzuführer (10), umfassend:
einen Zuführer-Hauptkörper (20);
ein Antriebszahnrad (40), das ein Zahnrad ist das so konfiguriert ist, dass es in Zuführlöcher (112) eingreift, die in einem Trägerband (100) vorgesehen sind, das ein Basisband (110) zur Aufnahme eines elektronischen Bauteil (P) und ein mit einer oberen Oberfläche des Basisbandes (110) verbundenes Abdeckband (120) aufweist, wobei das Antriebszahnrad (40) drehbar im Zuführer-Hauptkörper (20) vorgesehen ist und so konfiguriert ist, dass es von einem Motor (41) angetrieben wird und das elektronische Bauteil (P) durch Pitch-Vorschub des Trägerbandes (100) zu einer vorgegebenen Bauteilzuführposition (Ps) transportiert;
einen Abziehabschnitt (60), der eine Abziehklinge (61) umfasst, und von einer Eingriffsposition des Antriebszahnrads (40) und der Zuführlöcher (112) aus auf einer stromaufwärtigen Seite in einer Förderrichtung des Trägerbands (100) vorgesehen ist, und der so konfiguriert ist, dass er zumindest einen Teil eines Verbindungsabschnitts (101) zwischen dem Abdeckband (120) und dem Basisband (110) abzieht;
einen ersten Bandpressabschnitt (50), der so konfiguriert ist, dass er das Trägerband (100) an einer Position presst, an der das Abdeckband (120) durch die Abziehklinge (61) abgezogen wird, an der Bauteilzuführposition (Ps) und an der Eingriffsposition des Antriebszahnrads (40) und der Zuführlöcher (112);
ein manuelles Zahnrad (70), das ein Zahnrad ist das mit den Zuführlöchern (112) in Eingriff gebracht werden kann und auf einer stromaufwärtigen Seite des ersten Bandpressabschnitts (50) vorgesehen ist; und
einen zweiten Bandpressabschnitt (80), der so konfiguriert ist, dass er das Trägerband (100) über das manuelle Zahnrad (70) presst, um einen Zustand, in dem die Zuführlöcher (112) im Eingriff mit dem manuellen Zahnrad (70) sind, aufrechtzuerhalten,
**dadurch gekennzeichnet, dass**
das manuelle Zahnrad (70) im Zuführer-Hauptkörper (20) so vorgesehen ist, dass es drehbar ist an einer Position, in der ein Förderabstand des Trägerbands (100) von der Eingriffsposition des manuellen Zahnrades (70) mit den Zufuhrlöchern (112) zu der Abziehklinge (61) länger ist als eine Förderabstand des Trägerbandes (100) von der Abziehklinge (61) zur Bauteilzuführposition (Ps), und das so konfiguriert ist, dass sie manuell betätigt werden kann, um das Trägerband (100), das von einer Spule (R), um die das Trägerband (100) gewickelt ist, abgezogen wird, zum ersten Bandpressabschnitt (50) zu fördern.

2. Bandzuführer (10) nach Anspruch 1, wobei die Eingriffsposition des Antriebszahnrads (40) und der Zuführlöcher (112) an einer Position vorgesehen ist, die näher an der Bauteilzuführposition (Ps) liegt als die Abziehklinge (61).

3. Bandzuführer (10) nach Anspruch 1 oder 2, weiterhin umfassend: einen Sammelabschnitt (59), der konfiguriert ist um das Trägerband (100), nachdem das elektronische Bauteil (P) aufgenommen ist, und das Abdeckband (120), das mit dem Trägerband (100) verbunden war, auf einer in der Förderrichtung des Trägerbands (100) stromabwärtigen Seite von der Bauteilzuführposition (Ps) zu sammeln.

4. Bandzuführer (10) nach einem der Ansprüche 1 bis 3,
wobei der erste Bandpressabschnitt (50) so konfiguriert ist, dass er das Trägerband (100) presst in einem Zustand, in dem das Trägerband (100) horizontal ist, und
der zweite Bandpressabschnitt (80) so konfiguriert ist, dass er das Trägerband (100) in einem Zustand presst, in dem der zweite Bandpressabschnitt (80) derart geneigt ist, dass er von der stromaufwärtigen Seite in der Förderrichtung des Trägerbands (100) zur stromabwärtigen Seite ansteigt.

5. Bandzuführer (10) nach Anspruch 4, weiterhin umfassend:
ein Vorspannelement (13), das so konfiguriert ist, dass es den zweiten Bandpressabschnitt (80) in Bezug auf den Zuführer-Hauptkörper (20) nach unten vorspannt.

6. Bandzuführer (10) nach einem der Ansprüche 1 bis 5,
wobei die Bauteilzuführposition (Ps) oberhalb einer Position vorgesehen ist, an der das Antriebszahnrad (40) angeordnet ist, gesehen in einer Richtung der Drehachse des Antriebszahnrads (40).

## Revendications

1. Dispositif d'alimentation en bande (10) comprenant :
un corps principal de dispositif (20),
un pignon d'entraînement (40) qui est un pignon configuré pour s'engrener avec des trous d'avance (112) disposés sur une bande porteuse (100) comportant une bande de base (110) accueillant un composant électronique (P) et une bande de couverture (120) soudée sur la surface supérieure de la bande de base (110), le pignon d'entraînement (40) étant disposé pour pouvoir tourner dans le corps principal de dispositif (20) et configuré pour être entraîné par un moteur (41) et pour transporter le composant électronique (P) vers une position prédéterminée de délivrance de composant (Ps) grâce à une avance par pas de la bande porteuse (100),
une section de délaminage (60) comprenant une lame de délaminage (61) disposée du côté amont dans la direction de transport de la bande porteuse (100) depuis une position de mise en prise du pignon d'entraînement (40) et des trous d'avance (112), laquelle est configurée pour détacher au moins une partie d'une portion de liaison (101) entre la bande de couverture (120) et la bande de base (110),
une première section de compression de bande (50) configurée pour comprimer la bande porteuse (100) à une position où la bande de couverture (120) est détachée par la lame de délaminage (61) au niveau de la position de délivrance de composant (Ps), et à une position de mise en prise du pignon d'entraînement (40) et des trous d'avance (112),
un pignon manuel (70) qui est un pignon pouvant s'engrener avec les trous d'avance (112) et qui est disposé sur le côté amont de la première section de compression de bande (50), et
une seconde section de compression de bande (80) configurée pour comprimer la bande porteuse (100) au-dessus du pignon manuel (70) de sorte à maintenir les trous d'avance (112) en prise avec le pignon manuel (70),
**caractérisé en ce que :**
le pignon manuel (70) est placé dans le corps principal de dispositif (20) pour pouvoir tourner à une position où la distance de transport de la bande porteuse (100) depuis la position de mise en prise du pignon manuel (70) avec les trous d'avance (112) jusqu'à la lame de délaminage (61) est plus longue que la distance de transport de la bande porteuse (100) depuis la lame de délaminage (61) jusqu'à la position de délivrance de composant (Ps), lequel est configuré pour être manoeuvré manuellement pour transporter la bande porteuse (100) extraite d'une bobine (R) autour de laquelle est bobinée la bande porteuse (100) jusqu'à la première section de compression de bande (50).

2. Dispositif d'alimentation en bande (10) selon la revendication 1, dans lequel la position de mise en prise du pignon d'entraînement (40) et des trous d'avance (112) est prévue pour être à une position plus proche de la position de délivrance de composant (Ps) que de la lame de délaminage (61) .

3. Dispositif d'alimentation en bande (10) selon la revendication 1 ou la revendication 2, comprenant en outre : une section de recueil (59) configurée pour recueillir la bande porteuse (100) après que le composant électronique (P) a été prélevé et la bande de couverture (120) collée à la bande porteuse (100) à l'aval dans la direction de transport de la bande porteuse (100) depuis la position de délivrance de composant (Ps).

4. Dispositif d'alimentation en bande (10) selon l'une quelconque des revendications 1 à 3,
dans lequel la première section de compression de bande (50) est configurée pour comprimer la bande porteuse (100) de sorte à ce que la bande porteuse (100) soit horizontale, et
la seconde section de compression de bande (80) est configurée pour comprimer la bande porteuse (100) de sorte à ce que la seconde section de compression de bande (80) soit inclinée pour s'élever en direction de l'aval depuis l'amont dans la direction de transport de la bande porteuse (100).

5. Dispositif d'alimentation en bande (10) selon la revendication 4, comprenant en outre :
un élément de sollicitation (13) configuré pour contraindre la seconde section de compression de bande (80) vers le bas par rapport au corps principal de dispositif (20) .

6. Dispositif d'alimentation en bande (10) selon l'une quelconque des revendications 1 à 5,
dans lequel la position de délivrance de composant (Ps) est disposée au-dessus d'une position située où est placé le pignon d'entraînement (40) lorsqu'il est vu dans la direction de l'axe de rotation du pignon d'entraînement (40).
